# EUROPEAN PATENT APPLICATION

(11) **EP 1 204 299 A1**
(43) Date of publication of application: **08.05.2002**
(21) Application number: 01926101.5
(22) Date of filing: 01.05.2001
(51) Int. Cl.: H05B 3/20, H05B 3/00, H01L 21/66, H01L 21/68, H01L 21/027

(54) **CERAMIC HEATER AND METHOD OF CONTROLLING TEMPERATURE OF THE CERAMIC HEATER**

(30) Priority: 29.04.2000 JP 2000169735
(71) Applicant: IBIDEN CO., LTD., Ogaki-shi Gifu-ken 503-0917 (JP)
(72) Inventor: OHASHI, Jun, Ibi-gun Gifu 501-0601 (JP); KOGA, Yasutaka, Ibi-gun Gifu 501-0601 (JP)
(74) Representative: Grünecker, Kinkeldey, Stockmair & Schwanhäusser Anwaltssozietät
(86) International application number: JP0103778
(87) International publication number: WO0184888

(57) **Abstract**

By dividing a resistor heating body into 2 or more circuits at outer peripheral side and inner peripheral side and feeding different powers to these circuits based on results of temperatures measured through a temperature measuring means to conduct temperature control, the temperature at the outer peripheral side is made equal to or more than the temperature at the inner peripheral side to uniformize the temperature distribution of the substrate heating face in a radial direction and make small a temperature difference of a heating face for silicon wafer.

## Description

### TECHNICAL FIELD

This invention relates to a ceramic heater mainly used in a semiconductor field and more particularly to a ceramic heater being excellent in the uniform controllability of temperature distribution of a heating face of a substrate and a process for controlling a temperature thereof.

### BACKGROUND ART

Recently, semiconductors are importantly used as an inevitable part in not only an electronic industry but also other various industries. For example, a typical semiconductor chip is produced by slicing a silicon single crystal in a given thickness to prepare a silicon wafer and then forming plural integrated circuits or the like on the silicon wafer.

In the production step of this semiconductor chip, the silicon wafer placed on an electrostatic chuck is subjected to various treatments such as etching, CVD and the like to form semiconductor circuits and the like, or a resin for a resist is applied thereto and heated or dried. In such treatments is frequently used a metal heater wherein a resistor heating body is arranged on a rear face of a metal plate made of aluminum.

However, such a metal heater has the following problems. Since a substrate is made of a metal, the substrate must be made thick (about 15 mm). Because, when the metal substrate is thin, warping or strain is generated by thermal expansion accompanied with the heating, and hence the silicon wafer placed on the metal substrate is broken or inclined. On the other hand, as the thickness of the metal substrate becomes thicker, the heater becomes heavier and bulky.

And also, the heater using the metal substrate becomes thick, so that there is a problem that the temperature of the substrate does not rapidly follow to the change of voltage or current quantity and the temperature control is difficult.

On the contrary, JP-B-8-8247 and the like have proposed a technique that a nitride ceramic is used as a substrate and the temperature control is conducted while measuring a temperature near to a resistor heating body. However, if it is intended to heat the silicon wafer by using this technique, there is caused a problem that the silicon wafer is broken by thermal shock resulted from the temperature difference in the substrate surface.

Now, the inventors have made various studies with respect to the cause of the silicon wafer breakage. As a result, the breakage of the silicon wafer (hereinafter referred to as a wafer simply) though the temperature control is conducted is confirmed due to the fact that the temperature of an outer peripheral portion of the substrate is lowered by heat dissipation and if the whole of the resistor heating body is controlled so as to render into a uniform temperature, the ununiform temperature distribution is rather caused to break the wafer.

And also, it is newly confirmed that such an ununiformity of the temperature distribution appeared in the ceramic substrate becomes conspicuous when the thermal conductivity as in nitride ceramic, carbide ceramic or the like is high.

Moreover, JP-A-6-252055 proposes a control technique that the temperature near to a central portion of the substrate is controlled to a higher level than the temperature of the outer peripheral portion of the substrate, and JP-A-63-216283 proposes a technique that the circuit of the resistor heating body is divided to control the temperature of the outer peripheral portion in the resistor heating body to a high level. However, these known techniques are concerned with a method wherein the control is conducted by previously determining the temperature schedule. In the actual heating of the wafer, disturbance is caused likewise the case that the low temperature wafer is rapidly heated, so that the control in case of previously determining the temperature schedule can not cope with a case of generating unexpected temperature change.

An object of the invention is to propose a ceramic heater having an excellent uniformity of a temperature distribution on a heating surface of a substrate and a method of controlling a temperature thereof.

### DISCLOSURE OF THE INVENTION

The inventors have made various studies on the above subject matter. As a result, it has been found that the breakage of the wafer can be prevented by dividing the circuit of the resistor heating body into two or more circuits at an outer peripheral side and an inner peripheral side of the substrate and charging different powers to the above circuits based on results of temperature measured by a temperature measuring means and raising the temperature so that the temperature of the outer peripheral side is made equal to or higher than the temperature of the inner peripheral side to thereby uniformize the temperature distribution in the radial direction of the heating surface of the substrate and make small the temperature difference in the heating face of the silicon wafer, and even if the unexpected temperature change is generated, the uniform temperature control can be attained, and the invention has been accomplished by the following gist and construction.

That is, the invention is a ceramic heater comprising a ceramic substrate provided on its surface or in its inside with a resistor heating body, a temperature measuring means for measuring a temperature of the ceramic substrate or an objective to be heated, a control unit of feeding a power to the resistor heating body, a memory unit of storing temperature data measured by the temperature measuring unit, a calculation unit of calculating power to be fed to the resistor heating body from the temperature data, characterized in that the resistor heating body is constituted by two or more circuits capable of controlling the temperature independently, in which a temperature of a circuit located at an outer peripheral portion among these circuits is controlled so as to be made equal to or higher than a temperature of a circuit located at an inner peripheral portion.

The control unit is characterized by consisting of a power source feeding power to the resistor heating body and a control part of controlling the power source.

The temperature measuring means is characterized by using a temperature measuring element such as a thermocouple.

The temperature measuring means is characterized by using a temperature measuring element such as a thermoviewer.

And also, the invention lies in a method of controlling a temperature of a substrate in a ceramic heater comprising a ceramic substrate provided on its surface or in its inside with a resistor heating body, a temperature measuring means for measuring a temperature of the ceramic substrate or an objective to be heated, a control unit of feeding a power to the resistor heating body, a memory unit of storing temperature data measured by the temperature measuring unit, a calculation unit of calculating power to be fed to the resistor heating body from the temperature data, characterized in that the resistor heating body is constituted by two or more circuits capable of controlling the temperature independently, and a temperature of a circuit located at an outer peripheral portion among these circuits is controlled so as to be made equal to or higher than a temperature of a circuit located at an inner peripheral portion.

Moreover, the control unit is constructed with a power source feeding power to the resistor heating body and a control part of controlling the power source, and is preferable to conduct the temperature control by feeding different powers to the circuit located at the outer peripheral portion and the circuit located at the inner peripheral portion based on temperature data measured by the temperature measuring means.

### BRIEF DESCRIPTION OF THE DRAWINGS

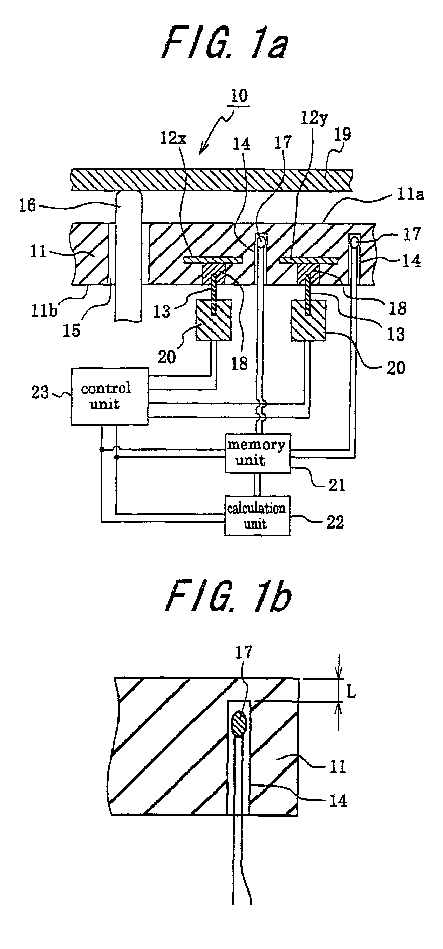

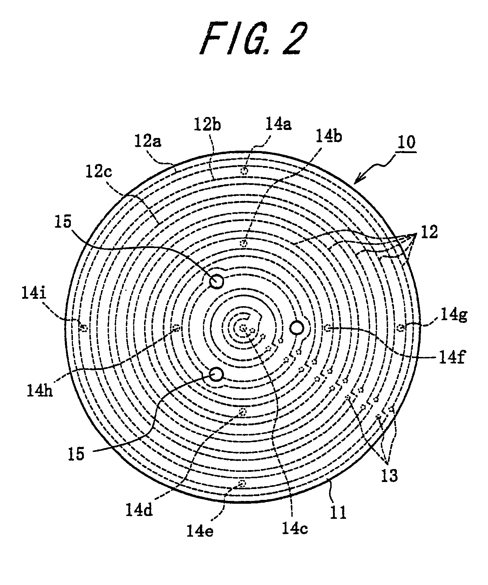

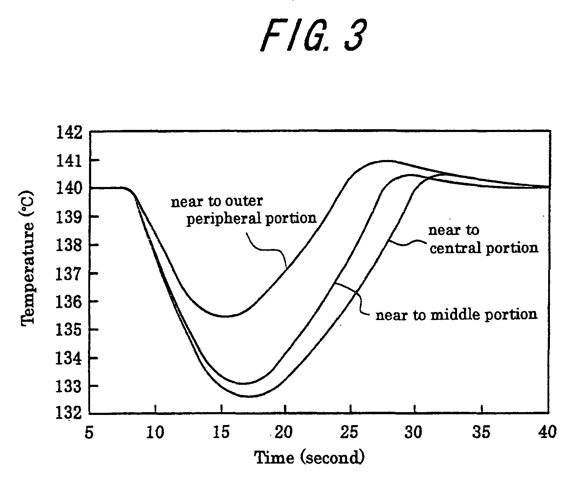

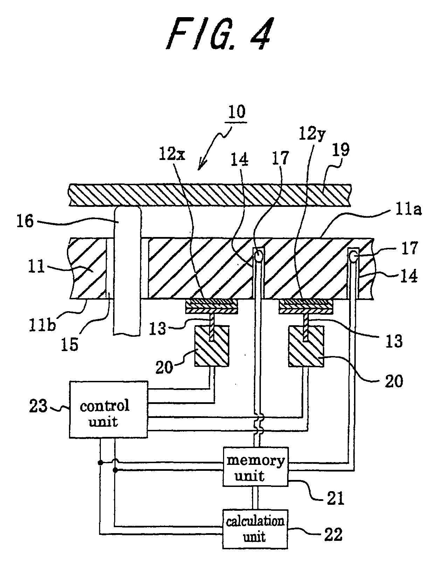

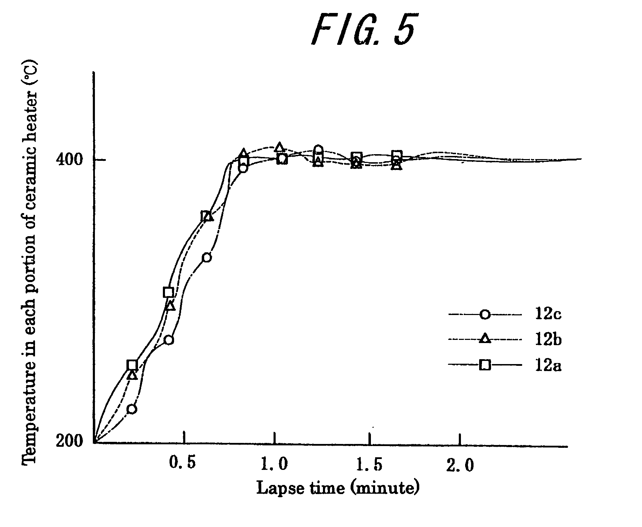

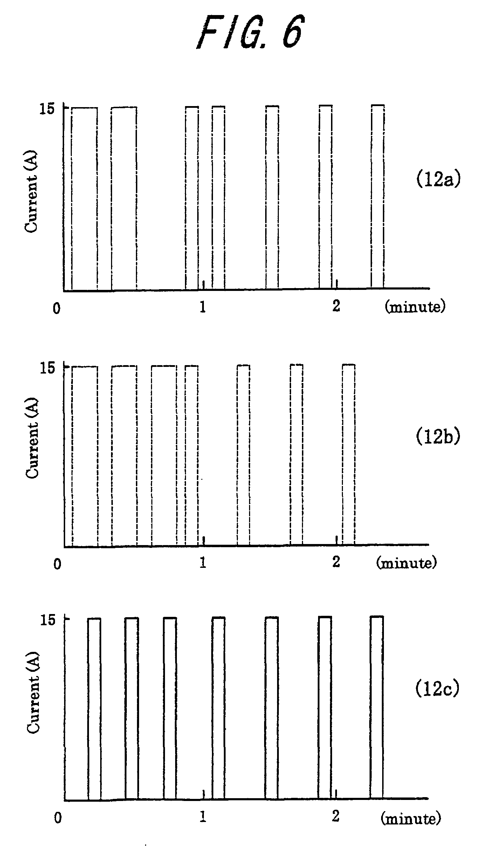

FIG. 1a is a schematic block diagram illustrating an embodiment of the ceramic heater (including a heating body therein) according to the invention, and FIG. 1b is a partially enlarged section view of a ceramic substrate. FIG. 2 is a schematic plan view illustrating an embodiment of a resistor heating body in the ceramic heater according to the invention. FIG. 3 is a graph showing a change of temperature distribution at various places in a radial direction of the ceramic substrate. FIG. 4 is a schematic block diagram illustrating another embodiment of the ceramic heater (including a heating body outside thereof) according the invention. FIG. 5 is a graph showing a temperature profile of a ceramic heater in Example 4. FIG. 6 is a graph showing a power (current) profile of a ceramic heater in Example 4.

### BEST MODE FOR CARRYING OUT THE INVENTION

In the ceramic heater according to the invention, the substrate is a ceramic substrate, and the resistor heating body is formed in the inside or the surface of the substrate, particularly in the surface opposite to the heating face for the wafer (hereinafter referred to as a heating face of the substrate). This ceramic substrate is provided with a temperature measuring element for measuring the temperature of the substrate, a control unit of feeding power to the resistor heating body, a memory unit of storing temperature data measured by the temperature measuring element, and a calculation unit of calculating power required for the resistor heating body from the temperature data.

A characteristic feature of the ceramic heater lies in that the resistor heating body is constituted with two or more circuits capable of controlling the temperature independently and the temperature of the circuit located at the outer peripheral portion side among these circuits is controlled to be made equal to or higher than the temperature of the circuit located at the inner peripheral portion side and as a result the heating face of the ceramic substrate indicates the uniform temperature distribution as a whole.

By the split type construction of the resistor heating body as mentioned above can be accurately controlled the necessary power feeding to the each resistor heating body based on the measured results of the temperature at places of the ceramic substrate through the temperature measuring element. Thus, the temperature distribution of the heating face of the substrate can be uniformly controlled. In the invention, the quantity of power fed is particularly increased at the outer peripheral portion side of the ceramic substrate appearing the temperature drop, so that the above problems in the conventional techniques can be avoided to always maintain the temperature of the heating face of the substrate and hence attain the prevention of wafer breakage.

As a result of the above, the uniform heating of the wafer can be realized, so that the drying of the resist on the wafer surface and the surface treatment such as CVD, sputtering or the like can be made uniform.

FIG. 1a is a partial section view of an embodiment of the ceramic heater 10 including a resistor heating body therein, and FIG. 1b is a partially enlarged section view illustrating an embedded portion of a temperature measuring element. And also, FIG. 2 is a plan view of a ceramic substrate illustrating an arrangement of the resistor heating body included in the ceramic heater 10 shown in FIG. 1a.

Numeral 11 is a ceramic substrate, which is formed in form of a circle as shown in FIG. 2. In the inside of the ceramic substrate 11 are embedded two kinds of resistor heating bodies 12 (12x, 12y) capable of controlling temperature independently. The pattern of these resistor heating bodies is a concentric circular pattern for conducting temperature control so as to uniformize the whole temperature of the heating face 11a of the substrate as shown. And also, the resistor heating bodies 12 are connected so as to be a line as a set of double concentric circles approaching to each other, both ends of which are connected to terminal pins 13 as input and output terminals via through-holes 18. Furthermore, a socket 20 is attached to the terminal pin 13 and the socket 20 is connected to a control unit 23 provided with a power source.

Moreover, through-holes 15 for inserting lifter pins 16 are formed in the vicinity of a central portion of the ceramic substrate 11, and further plural bottomed holes 14a-14i for inserting thermocouples 17 as a temperature measuring element are formed in proper places of the ceramic substrate 11.

Into the ceramic substrate 11 is inserted a lifter pin 16 for supporting a wafer 19 on a heating face 11a of the substrate in such a manner that the carrying-in or carrying-out of the wafer 19 are conducted through lifting up and down of the lifter pin 16. That is, the wafer 19 is delivered onto a carrier (not shown) or received from the carrier while moving the lifter pin 16 in up-down direction. Moreover, the wafer 19 supported on the substrate heating face 11a can be heated by while supporting at a given distance apart from the substrate heating face 11a through the lifter pin 16 or a gap pin (not shown), and in this case the distance is desirable to be about 50-5000 µm.

In the ceramic substrate 11 are pierced bottomed-holes 14 from a bottom surface 11b opposite to the substrate heating face 11a, and thermocouples 17 as a temperature measuring element are embedded in and fixed to bottoms of the bottomed-holes, respectively. These thermocouples 17 are connected to a memory unit 21, at where the temperatures of the thermocouples 17 are measured every a given time and the data can be stored. The memory unit 21 is connected to a control unit 23 and a calculation 22, in which the calculation of voltage value controlling by the calculation unit 22 is conducted based on the data stored in the memory unit 21 and then a given voltage is applied from the control unit 23 to each of the resistor heating bodies 12 to uniformize the temperature of the substrate heating face 11a.

The method of controlling the temperature of the ceramic heater according to the invention will be described below.

As power is first fed to the ceramic heater 10 by actuating the control unit 23, the temperature of the ceramic substrate 11 itself starts to rise, but it is usual that the surface temperature in the outer peripheral portion of the substrate becomes slightly low. The temperature of the heating face 11a of the ceramic substrate 11 is measured by the thermocouple 17, and the measured temperature data are stored in the memory unit 21. Then, the measured temperature data are fed to the calculation unit 22, and a temperature difference or a difference ΔT to a set temperature at each measuring point is calculated at the calculation unit 22 and further a necessary data ΔW is calculated for uniformizing a temperature of the substrate heating face 11a. For example, the temperature difference ΔT is between an upper heating face of the resistor heating body 12x located at the inner peripheral side and an upper heating face of the resistor heating body 12y located at the outer peripheral side, and if the temperature of the upper heating face of the resistor heating body 12x located at the inner peripheral side is low, power data ΔW for rendering ΔT into zero is calculated and fed to the control unit 23, whereby power is fed to the resistor heating body 12x at the inner peripheral side or the resistor heating body 12y at the outer peripheral side to raise or drop the temperature.

As to a calculation algorithms of the power, a method of calculating a power required for temperature rise from a specific heat of the ceramic substrate 11 and a weight of a heating zone is simplest and a correction coefficient resulted from the resistor heating body pattern may be added thereto. And also, a temperature raising test is previously conducted for a specified resistor heating body pattern to measure factors of a temperature measuring position, a power fed and a temperature, and a power to be fed may be calculated from these factors. Furthermore, an applied voltage corresponding to the power calculated by the calculation unit 22 and a time are fed to the control unit 23, and power based thereon is fed to each of the resistor heating bodies 12x, 12y at the control unit 23.

In the temperature control method according to the invention, the calculation unit 22 is disposed in the control system, so that even if an unexpected temperature change is caused in the ceramic substrate 11, power for temperature uniformization can be calculated and hence a practical temperature control can be realized.

FIG. 3 is a graph showing a temperature change in the substrate heating face 11a of the ceramic substrate 11 when the temperature of the ceramic heater is raised to 140°C and then the wafer of 25°C is approached thereto up to a distance of 100 µm. After the dropped temperature is actually measured, power to be fed to the resistor heating body (12x, 12y) from the difference between the measured temperature and the set temperature and the temperature difference at each measuring point. According to the invention, therefore, even if any temperature change is caused, the temperature difference of the substrate heating face 11a can be always converged to adjust to the original set temperature. Even in FIG. 3, the temperature of the resistor heating body at the outer peripheral side is made high.

Each member constituting the ceramic heater according to the invention and the like will be described below. The thickness of the ceramic substrate 11 is favorable to be more than 1.5 mm but not more than 25 mm, particularly 0.5-5 mm. When the thickness is less than 0.5 mm, the strength lowers and the breakage is apt to be caused, while when it is more than 5 mm, heat is hardly transmitted and the efficiency of heating-cooling is degraded. A ceramic constituting the ceramic substrate 11 is desirable to be a nitride ceramic or a carbide ceramic. The nitride ceramic or carbide ceramic is small in the thermal expansion coefficient and considerably high in the mechanical strength as compared with the metal, so that even if the thickness of the heater plate 11 is made thin, the plate is not warped or crooked by heating. For this end, the ceramic substrate 11 can be made thin and light. Since such a ceramic substrate 11 is high in the heat conductivity and light, the surface temperature thereof rapidly follows the temperature change of the resistor heating body. That is, the surface temperature of the ceramic substrate can be accurately and rapidly controlled by varying voltage and current values to change the temperature of the resistor heating body.

As means for measuring the temperature of the ceramic substrate, a thermoviewer may be used in addition to the above thermocouple 17. In this connection, point temperature control is conducted in the thermocouple 17, but plane temperature control can be preferably conducted in the thermoviewer. And also, the temperature measurement through the temperature measuring means may measure the temperature of the wafer to be heated in addition to the ceramic substrate 11. When the temperature of the wafer 19 is directly measured, the temperature control can be accurately conducted.

The nitride ceramic includes, for example, aluminum nitride, silicon nitride, boron nitride, titanium nitride and so on. They may be used alone or in admixture of tow or more. And also, the carbide ceramic includes, for example, silicon carbide, zirconium carbide, titanium carbide, tantalum carbide, tungsten carbide and so on. They may be used alone or in admixture of two or more. Among them, aluminum nitride is most preferable. Because it has a highest thermal conductivity of 180 W/m.k and is excellent in the temperature followability and is apt to easily bring about the ununiform temperature distribution, but is effective to take a structure of forming the temperature measuring element as in the invention.

In a surface of the ceramic substrate 11 opposite to the substrate heating face 11a to be placed with the wafer 19 are formed bottomed-holes 14a-14i (hereinafter referred to as bottomed-hole 14 simply) toward the substrate heating face 11a. The bottom of the bottomed-hole 14 is desirable to be formed relatively near to the substrate heating face 11a rather than a position of the resistor heating body 12 (see FIG. 1a). Moreover, a distance L between the bottom of the bottomed-hole 14 and the substrate heating face 11a is 0.1 mm to 2/3 of the thickness of the ceramic substrate, desirably about 1/2 thereof (see FIG. 1b).

When the distance L is less than 0.1 mm, heat dissipation is caused to easily form the ununiform temperature distribution on the substrate heating face 11a, while when it exceeds 2/3, desirably 1/2 of the substrate thickness, the substrate is apt to be easily influenced by the temperature of the resistor heating body 11 and the temperature control is impossible and hence the ununiform temperature distribution is formed on the substrate heating face 11a.

The diameter of the bottomed-hole 14 is desirable to be 0.3 mm to 5 mm. When it is too large, the heat dissipation becomes large, while when it is too small, the workability lowers and the distance to the substrate heating face 11a can not be made equal.

As shown in FIG. 2, it is desirable that the bottomed-holes 14a-14i are arranged to be symmetrical with respect to a center of the ceramic substrate 11 and form a cross shape. Thus, the temperature of the substrate heating face as a whole can be measure.

According to such a structure, the temperature measuring position becomes near to the substrate heating face 11a rather than the resistor heating body 12 and it is possible to more accurately measure the temperature of the substrate heating face 11a heating the wafer 19. The results on the measured temperature are stored in the memory unit 21, and the voltage to be fed to resistor heating body 12 is calculated based on the temperature data stored in the memory unit 21, and the controlled voltage based on the calculation result is applied to the heating body 12 through the control unit 23, so that it is possible to uniformly heat the whole of the substrate heating face 11a and hence uniformly heat the whole of the wafer.

The temperature measuring element includes, for example, a thermocouple, a temperature measuring platinum resistor, a thermistor and so on. The thermocouple includes, for example, K-type, R-type, B-type, S-type, E-type, J-type, T-type thermocouples and the like, and among them K-type thermocouple is favorable. A size of a joint portion in the thermocouple is equal to or more than a diameter of a filament and is desirable to be not more than 0.5 mm. When the joint portion is large, heat capacity becomes large and the responsibility lowers. Moreover, it is difficult to make the size smaller than the diameter of the filament.

The temperature measuring element may be adhered to the bottom of the bottomed-hole 14 by using a gold solder, a silver solder or the like, or may be sealed with an inorganic adhesive or a heat-resistant resin after the insertion into the bottomed-hole 14, or both may be used together.

As the heat-resistant resin, mention may be made of a thermosetting resin, particularly an epoxy resin, a polyimide resin, bismaleimide-triazine resin and the like. These resins may be used alone or in admixture of two or more.

As the gold solder, at least one selected from 37-80.5 wt% Au-63-19.5 wt% Cu alloy and 81.5-82.5 wt% Au-18.5-17.5 wt% Ni alloy is desirable. They have a melting temperature of not lower than 900°C and hardly fuse even at a higher temperature zone. As the silver solder, Ag-Cu system may be used.

As shown in FIG. 2, the resistor heating body 12 is desirable to be divided into at least two or more circuits, preferably 2 to 30 circuits, desirably 2-10 circuits. By dividing the resistor heating body 12 into plural circuits can be controlled power fed to each of the circuits to finely control a heat generation quantity of the resistor heating body 12 and the temperature distribution of the substrate heating face 11a can be accurately controlled.

Moreover, the temperature of the ceramic heater used may be 100°C to 800°C. Moreover, the diameter of the ceramic heater may be not less than 190 mm.

### [Examples]

### (Example 1) Manufacture of Ceramic heater of nitride ceramic (see FIG. 4, type of arranging the heating body located at the outside).

(1) A granulated powder is prepared by spray drying a composition comprising 100 parts by weight of aluminum nitride powder (average particle size: 1.1 µm), 4 parts by weight of yttria (average particle size: 0.4 µm), 12 parts by weight of an acrylic binder and an alcohol.
(2) Then, the granulated powder is placed in a mold and shaped into a plate form to obtain a green shaped body (green).
(3) The green shaped body is hot pressed at 1800°C under a pressure of 200 kg/cm2 to obtain an aluminum nitride plate body having a thickness of 3 mm. Then, a disc-shaped body having a diameter of 210 mm is cut out from the plate body as a ceramic plate-shaped body (heater plate).
   The shaped body is subjected to a drilling to form portions corresponding to through-holes 15 for inserting lifter pins 16 for a silicon wafer and portions corresponding to bottomed-holes 14 for embedding thermocouples 17 (diameter: 1.1 mm, depth: 2 mm).
(4) A conductor paste is printed onto a ceramic substrate 11 obtained in the above item (3) through a screen printing. A printed pattern is a concentrically circular pattern as shown in FIG. 2.
   As the conductor paste is used Solvest PS603D made by Tokuriki Kagaku Kenkyusho used in the formation of through-hole for a printed wiring board. This conductor paste is a silver-lead paste and contains 7.5 parts by weight of metal oxides comprising lead oxide (5 wt%), lead oxide (55 wt%), silica (10 wt%), boron oxide (25 wt%) and alumina (5 wt%) based on 100 parts by weight of silver. And also, silver particles have an average particle size of 4.5 µm and are flaky.
(5) Then, the ceramic substrate 11 printed with the conductor paste is heated and fired at 780°C to sinter silver and lead in the conductor paste and bake on the surface of the substrate to thereby form a resistor heating body 12. The silver-lead resistor heating body 12 has a thickness of 5 µm, a width of 2.4 mm and an area resistivity of 7.7 mΩ/ .
(6) Next, the ceramic substrate 11 prepared in the above item (5) is immersed in an electroless nickel plating bath of an aqueous solution having concentrations of 80 g/l of nickel sulfate, 24 g/l of sodium hypophosphite, 12 g/l of sodium acetate, 8 g/l of boric acid and 6 g/l of ammonium chloride to precipitate a metal coated layer (nickel layer) having a thickness of 1 µm on the surface of the silver-lead resistor heating body 12.
(7) Onto a portion to be attached with a terminal for ensuring a connection to a power source is printed a silver-lead solder paste (made by Tanaka Kikinzoku) through a screen printing to form a solder layer.
   Then, a terminal pin 13 of Kovar is placed on the solder layer and flowed by heating at 420°C, whereby the terminal pin 13 is attached to the surface of the resistor heating body 12.
(8) A thermocouple 17 for the temperature control is fitted into the bottomed-hole 14 and embedded and fixed with a ceramic adhesive (Aaronceramic, made by Toa Gosei Co., Ltd.) to obtain a ceramic heater 10.

### (Example 2) Temperature control of ceramic heater

(1) There is provided a temperature controller (E5ZE, made by Omuron Co., Ltd.) provided with a control unit having a power source, a memory unit and a calculation unit, in which a wiring from a control unit 23 is connected to the ceramic heater 10 manufactured in Example 1 through the terminal pin 13 (see FIG. 4) and a wiring from the thermocouple 17 is connected to a memory unit 21 and a silicon wafer is placed on the ceramic heater 10. Moreover, bottomed-holes 14a-14c of the ceramic heater 10 are formed at the same positions as the bottomed-holes in the ceramic heater 10 shown in FIG. 2 though they are not shown in FIG. 4. Further, the resistor heating bodies 12a-12c are formed at the same positions as the resistor heating bodies 12a-12c in the ceramic heater 10 shown in FIG. 2.
(2) Then, a temperature is raised to 200°C once by applying a voltage to the ceramic heater 10 and then further raised to 200°C-400°C, which is measured by thermocouples disposed in the bottomed-holes 14a-14c. The measured results are shown in FIG. 5.

And also, profiles of power (indicated by current value) fed to the resistor heating bodies 12a, 12b, 12c are shown in FIG. 6. In FIG. 5, a temperature at each portion of the ceramic heater is plotted on a vertical axis and a lapse time is plotted on a horizontal axis, and in FIG. 6, a current value is plotted on a vertical axis and a time is plotted on a horizontal axis.

As seen from FIG. 5, after the current is flowed to the ceramic heater 10, the temperature of the resistor heating body 12y at the outer peripheral side is made higher than that of the resistor heating body 12x at the inner peripheral side, whereby the temperature of the ceramic heater becomes uniform in a short time and hence the silicon wafer 19 placed on the ceramic heater 10 is uniformly heated without breaking in the heating process.

Furthermore, when the temperature of the ceramic heater 10 is raised to 140°C and the wafer 19 of 25°C provided with a temperature sensor is held at a distance of 100 µm apart from the wafer heating face of the heater, the temperature change of the wafer heating face is shown in FIG. 3. As seen from this figure, the dropped temperature is actually measured to determine a difference to the set temperature and calculate power quantity required for each heating body circuit, whereby the temperature of the resistor heating body 14y at the outer peripheral side can be raised at a higher level to adjust to the set temperature while converging the temperature difference in the substrate heating face. To this end, even if non-steady temperature change is caused, it can be rapidly returned to the original temperature. On the contrary, the conventional technique has no calculation unit, so that the temperature is only raised according to the previously set temperature profile and hence the temperature control can not be conducted in case of the non-steady temperature change.

As mentioned above, in the ceramic heater according to the invention, the temperature of the heating face for the silicon wafer can be always uniformized by making the temperature of the resistor heating body at the outer peripheral side higher than or equal to that at the inside.

### INDUSTRIAL APPLICABILITY

The ceramic heater according to the invention is used in apparatuses for the manufacture of semiconductors or the inspection of the semiconductor. For example, an electrostatic chuck, a wafer prober, a susceptor and the like are mentioned. In case of using the electrostatic chuck, a chuck top conductor layer is formed on the surface as a conductor, and a guard electrode and a ground electrode are formed in the inside as a conductor pair. And also, the ceramic substrate for the semiconductor apparatus according to the invention is favorable to be used at not lower than 100°C, desirably not lower than 200°C. The temperature of upper limit is 800°C.

## Claims

1. A ceramic heater comprising a ceramic substrate provided on its surface or in its inside with a resistor heating body, a temperature measuring means for measuring a temperature of the ceramic substrate or an objective to be heated, a control unit of feeding a power to the resistor heating body, a memory unit of storing temperature data measured by the temperature measuring means, a calculation unit of calculating power to be fed to the resistor heating body from the temperature data, **characterized in that** the resistor heating body is constituted by two or more circuits capable of controlling the temperature independently, in which a temperature of a circuit located at an outer peripheral portion among these circuits is controlled so as to be made equal to or higher than a temperature of a circuit located at an inner peripheral portion.

2. A ceramic heater according to claim 1, wherein the control unit consists of a power source feeding power to the resistor heating body and a control part of controlling the power source.

3. A ceramic heater according to claim 1, wherein the temperature measuring means is a temperature measuring element such as a thermocouple.

4. A ceramic heater according to claim 1, wherein the temperature measuring means is a temperature measuring element such as a thermoviewer.

5. A method of controlling a temperature of a ceramic heater comprising a ceramic substrate provided on its surface or in its inside with a resistor heating body, a temperature measuring means for measuring a temperature of the ceramic substrate or an objective to be heated, a control unit of feeding a power to the resistor heating body, a memory unit of storing temperature data measured by the temperature measuring means, a calculation unit of calculating power to be fed to the resistor heating body from the temperature data, **characterized in that** the resistor heating body is constituted by two or more circuits capable of controlling the temperature independently, and a temperature of a circuit located at an outer peripheral portion among these circuits is controlled so as to be made equal to or higher than a temperature of a circuit located at an inner peripheral portion.

6. The method of controlling a temperature of ceramic heater according to claim 5, wherein the control unit is constructed with a power source feeding power to the resistor heating body and a control part of controlling the power source, and conducts the temperature control by feeding different powers to the circuit located at the outer peripheral portion and the circuit located at the inner peripheral portion based on temperature data measured by the temperature measuring means.
